# EUROPÄISCHE PATENTSCHRIFT

(11) **EP 3 449 499 B1**
(45) Veröffentlichungstag und Bekanntmachung des Hinweises auf die Patenterteilung: **22.07.2026**
(21) Anmeldenummer: 17708474.6
(22) Anmeldetag: 01.03.2017
(51) Int. Cl.: H10P 74/00, H10D 64/23

(54) **LEISTUNGSTRANSISTOR, TREIBER UND ENDSTUFE**
POWER TRANSISTOR, DRIVER, AND POWER AMPLIFIER
TRANSISTOR DE PUISSANCE, MOYEN DE PILOTE ET AMPLIFICATEUR DE PUISSANCE

(30) Priorität: 29.04.2016 DE 102016207349
(43) Veröffentlichungstag der Anmeldung: 06.03.2019
(73) Patentinhaber: Robert Bosch GmbH, 70442 Stuttgart (DE)
(72) Erfinder: LOHMEYER, Henning, 72762 Reutlingen (DE); MANN, Alexander, 72805 Lichtenstein (DE); SCHNEIDER, Daniel, 72800 Eningen Unter Achalm (DE)
(86) Internationale Anmeldenummer: PCT/EP2017/054788
(87) Internationale Veröffentlichungsnummer: WO 2017/186382

(56) Entgegenhaltungen:
- US-A1- 2012 212 245
- RITTER MATTHIAS ET AL: "A proposal for early warning indicators to detect impending metallization failure of DMOS transistors in cyclic operation", 2014 INTERNATIONAL CONFERENCE ON MICROELECTRONIC TEST STRUCTURES (ICMTS), IEEE, 23 March 2015 (2015-03-23), pages 18 - 22, XP032776361, ISSN: 1071-9032, ISBN: 978-1-4799-2193-5, [retrieved on 20150512], DOI: 10.1109/ICMTS.2015.7106097
- PHAM GIMI ET AL: "Influence of metallization layout on aging detector lifetime under cyclic thermo-mechanical stress", 2016 IEEE INTERNATIONAL RELIABILITY PHYSICS SYMPOSIUM (IRPS), IEEE, 17 April 2016 (2016-04-17), XP032969763, DOI: 10.1109/IRPS.2016.7574551
- PFOST MARTIN ET AL: "Influence of the On-Chip Metallization on Self-Heating in Integrated Power Technologies", IEEE TRANSACTIONS ON SEMICONDUCTOR MANUFACTURING, IEEE SERVICE CENTER, PISCATAWAY, NJ, US, vol. 27, no. 2, 1 May 2014 (2014-05-01), pages 169 - 177, XP011547051, ISSN: 0894-6507, [retrieved on 20140501], DOI: 10.1109/TSM.2014.2306683
- SIMON DAN ET AL: "Experimental Reliability Improvement of Power Devices Operated Under Fast Thermal Cycling", IEEE ELECTRON DEVICE LETTERS, IEEE SERVICE CENTER, NEW YORK, NY, US, vol. 36, no. 7, 1 July 2015 (2015-07-01), pages 696 - 698, XP011585545, ISSN: 0741-3106, [retrieved on 20150624], DOI: 10.1109/LED.2015.2432128
- ASAKURA H ET AL: "An Advanced Defect-Monitoring Test Structure for Electrical Screening and Defect Localization", IEEE TRANSACTIONS ON SEMICONDUCTOR MANUFACTURING, IEEE SERVICE CENTER, PISCATAWAY, NJ, US, vol. 17, no. 2, 10 May 2004 (2004-05-10), pages 104 - 110, XP011112474, ISSN: 0894-6507, DOI: 10.1109/TSM.2004.826996
- WERNER KANERT: "Reliability challenges for power devices under active cycling", RELIABILITY PHYSICS SYMPOSIUM, 2009 IEEE INTERNATIONAL, IEEE, PISCATAWAY, NJ, USA, 26 April 2009 (2009-04-26), pages 409 - 415, XP031496442, ISBN: 978-1-4244-2888-5

## Beschreibung

Die vorliegende Erfindung betrifft einen Leistungstransistor, einen Treiber und eine Endstufe.

### Stand der Technik

Leistungstransistoren, beispielsweise Feldeffekttransistoren, Bipolartransistoren beziehungsweise IGBTs (englisch: Insulated Gate Bipolar Transistoren), sind elektronische Halbleiterbauelemente zum Schalten oder Steuern von großen Spannungen, Strömen beziehungsweise Leistungen. Sie wirken als elektrischer Widerstand, der mithilfe eines Steuersignals den Strom eines Nutzsignals um mehrere Größenordnungen ändern kann. Das Steuersignal entspricht dabei für Feldeffekttransistoren einer Spannung am Gate, wohingegen Bipolartransistoren durch einen Strom an der Basis gesteuert werden.

Im Weiteren erfolgt die Erläuterung der vorliegenden Erfindung anhand eines FE-Leistungstransistors (FE steht für Feldeffekt), welche ebenso auf Bipolartransistoren beziehungsweise IGBTs (englisch: Insulated Gate Bipolar Transistoren), einer Kombination aus Bipolartransistor und steuerndem Feldeffektransistor, übertragbar ist.

FE-Leistungstransistoren werden beispielsweise als integrierte Treiber für den Automobilbereich, etwa als Treiber für Brems- und Einspritzventile verwendet. Weitere Anwendungsfälle im Automobilbereich umfassen Treiber für Signalgeber beispielsweise für einen Parkpiloten und für pulsweitenmoduliertes Einschalten von Kaltleitern - konfigurierte Lampentreiber. FE-Leistungstransistoren finden jedoch auch außerhalb des Automobilbereiches Anwendung.

Ein Einsatzbeispiel von FE-Leistungstransistoren im Automobilbereich ist die Verwendung als Low-Side-Schalter, also ein Schalter auf der Masse-Seite, um zyklisch induktive Lasten zu steuern, wie sie beispielsweise in Ventiltreiberanwendungen für anwendungsspezifisch integrierte Schaltungen (ASIC für englisch: application·specific integrated circuit) beziehungsweise für eine Fahrdynamikregelung (ESP für elektronisches Stabilitätsprogramm) oder ein Antiblockiersystem (ABS) auftreten. Typischerweise kommt es dabei zu Schaltpulsen, die auch als geklammertes Schalten einer induktiven Last (CIS für englisch: Clamped Inductive Switching) oder auch als wiederholtes Leistungspulsen (RPP für englisch: Repetitive Power Pulsing) bezeichnet werden. Vergleichbare Ereignisse mit wiederholter Pulsbelastung können auch bei Transistoren zur Steuerung von kleineren Lasten beziehungsweise Ohm'schen Lasten auftreten, wenn Fehlerzustände auftreten und beherrscht werden müssen.

Wiederkehrende Pulsereignisse führen in FE-Leistungstransistoren in Abhängigkeit ihres Arbeitspunktes, das heißt je nach Höhe der Drain-Source-Spannung und dem Maß der Gate-Source-Spannung im Vergleich zur Schwellspannung, zu einer Umsetzung von Verlustleistung im Bauteil und damit gegebenenfalls zu einer signifikanten Eigenerwärmung. Die entstehenden schnellen thermischen Zyklen können je nach Art des Ereignisses und des Lastprofiles eine signifikante thermomechanischen Belastung der Nutzmetallisierung der Bauelemente darstellen.

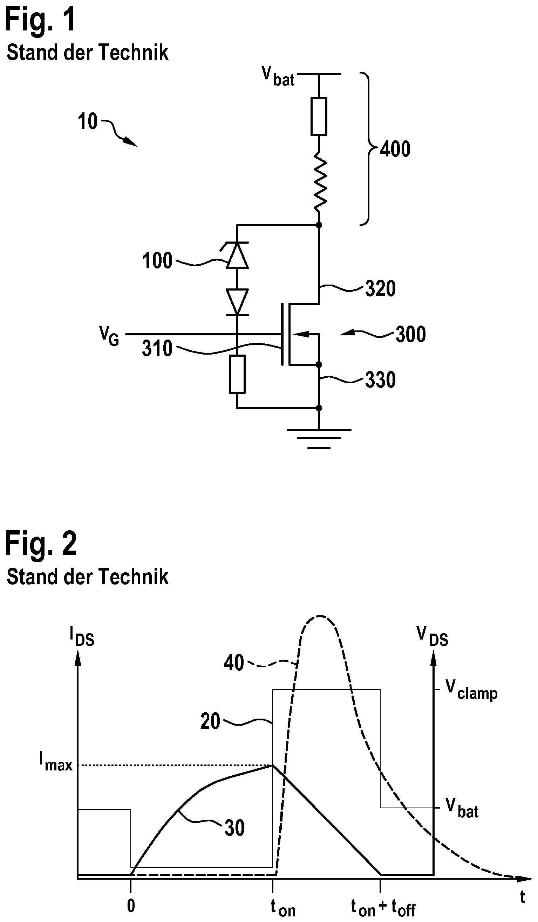

Eine Ausführungsform eines Low-Side-Schalters mit FE-Leistungstransistor nach Stand der Technik ist in Figur 1 gezeigt. Für diesen sind die schematischen Verläufe von Drainspannung 20, Drainstrom 30 und Temperatur 40 nach Stand der Technik während eines Schaltpulses des Low-Side-Schalters in Figur 2 aufgetragen.

Dabei verfügt der Low-Side-Schalter über einen FE-Leistungstransistor 300 und eine Gate-Ansteuerung in Form einer Zenerdiodenkette 100 zwischen Drain 320 und Gate 310 des FE-Leistungstransistors 300, die im Falle des Abschaltens der induktiven Last 400 einen kontrollierten Abbau der in der Last gespeicherten Energie erlauben, sodass die induzierte Spannung innerhalb der Bauelementspezifikation verbleibt.

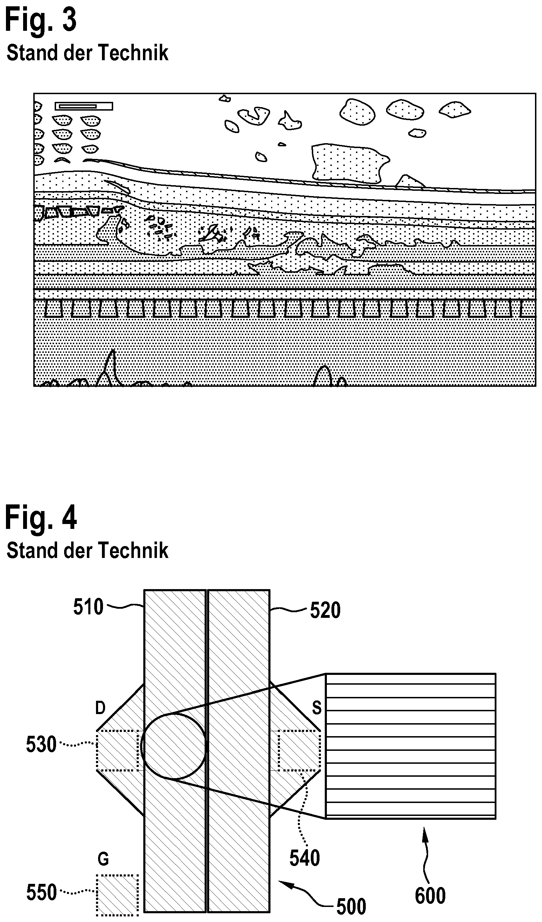

In der in Figur 1 gezeigten Ausführung der Endstufe 10 ergibt sich beim Ausschaltvorgang ein Puls hoher Leistung folgendermaßen: Steigt die Induktionsspannung über die Durchbruchspannung der Zenerdiodenkette 100 an, so kommt es zu einer Aufladung des Gates 320 des FE-Transistors 300, wodurch der FE-Transistor 300 exakt so weit über seine Schwellspannung angesteuert wird, dass er den induzierten Strom ableiten kann, sodass sich die in der induktiven Last 400 gespeicherte Energie abbaut. Dieser Betriebszustand erzeugt aufgrund der hohen Drainspannung kurzzeitig eine hohe Verlustleistung und führt somit zu einer signifikanten Eigenerwärmung der Endstufe. Je nach Größe der Endstufe und Pulslänge kann diese Erwärmung zu einer lateral sowie vertikal stark inhomogenen Temperaturverteilung führen. Aufgrund stark unterschiedlicher thermischer Ausdehnungskoeffizienten der innerhalb der Endstufenmetallisierung verwendeten Materialien für Leitbahnen und Dielektrika (beispielsweise Aluminium-Kupfer-Legierung (AlCu) oder Kupfer (Cu) als Leiterbahn und Siliziumdioxid (SiO₂) als Zwischenschichtdielektrikum) führt der Pulsbetrieb zu zusätzlichem thermomechanischen Stress. Über die Produktlebenszeit kann es derart zu einer zunehmenden Belastung des Metallisierungsgefüges kommen. Im Extremfall führt kumulative plastische Verformung der Leiterbahnen zu starkem mechanischen Stress im Zwischenschichtdielektrikum (ILD für: Inter Layer Dielektrikum) und letztlich zum Bruch des Selbigen. Im entstandenen Riss kann anschließend Metall aus den Leiterbahnen durch plastische Verformung eindringen und zum Kurzschluss der Drain-Source-Metallisierung führen, was den Ausfall des Bauelementes bedeutet (siehe Figur 3). In dieser Ausprägung wird der beschriebene Fehlermechanismus auch als temperaturinduzierte plastische Metallverformung (im Weiteren TPMD für englisch: temperature induced plastic metal deformation) bezeichnet.

Um durch TPMD bedingte Ausfälle zu verhindern, muss die auftretende Maximaltemperatur und der entstehende Temperaturgradient im Bauelement und der damit korrelierende thermomechanische Stress begrenzt werden. Dies geschieht durch eine geometrisch-optimale Auslegung des FE-Transistors bezüglich des erwarteten Lastprofils.

Tobias Smorodin et al. beschreiben in "A Temperature-Gradient Induced Failure Mechanism in Metallization Under Fast Thermal Cycling", IEEE Transactions on Device and Material Reliability, Vol. 8, No. 3, Sept. 2008, dass gezielte Provokationsdauerläufe zu zirkulär verteilten Ausfallorten innerhalb der Endstufen führen. Die Ausfallorte sind dabei mit dem Ort des maximalen Temperaturgradienten korreliert.

Mathias Ritter et al. schlagen in "A Proposal for Early Warning Indicators to Detect Impending Metalization Failure of DMOS Transistors in Cyclic Operation", IEEE Proc. ICMTS (Proceedings of the International Conference on Microelectronic Test Structures), März 2015 das Einbringen einer potentialfreien, überkritisch ausgelegten Metallmäanderstruktur in das Metallisierungssystem des FE-Transistors vor. Diese besteht aus den identischen Materialien und erfährt den gleichen thermomechanischen Stress wie das restliche Metallisierungssystem. Mittels der Mäanderstruktur kann der Leckstrom in Bezug auf Drain beziehungsweise Source und der Widerstand detektiert werden. Beide Größen werden durch den RPP-Stress beeinflusst und können derart Rückschlüsse auf den Alterungszustand des FE-Transistors liefern.

Auch die Arbeiten von PHAM GIMI ET AL: "Influence of metallization layout on aging detector lifetime under cyclic thermo-mechanical stress", 2016 IEEE INTERNATIONAL RELIABILITY PHYSICS SYMPOSIUM (IRPS), IEEE 17. April 2016 (2016-04-17) und von PFOST MARTIN ET AL: "Influence the On-Chip Metallization on Self- Heating in Integrated Power Technologies,IEEE TRANSACTIONS ON SEMICIIDUCTOR MANUFACTURING, IEEE SERVICE CENTER, PISCATAWAY, NJ, US, Bd. 27, Nr. 2, 1. Mai 2014 (2014-05-01), Seiten 169-177, befassen sich mit RPP-Stress.

### Offenbarung der Erfindung

Erfindungsgemäß wird ein Leistungstransistor gemäß Anspruch 1 vorgestellt.

Der Leistungstransistor umfasst einen aktiven Bereich und eine über dem aktiven Bereich angeordnete Metallisierungsebene zur Leistungsverteilung und zur Detektion eines bevorstehenden, durch wiederholtes Leistungspulsen verursachten Stress (RPP-Stress) bedingten Metallisierungsfehlers. Der Leistungstransistor umfasst weiterhin eine über der Metallisierungsebene angeordnete, weitere Metallisierungsebene, in der sich galvanisch getrennte Metallstreifen in eine Erstreckungsrichtung parallel zueinander erstrecken, von denen ein Paar zur Leistungsversorgung des Leistungstransistors dient. Der Leistungstransistor ist dadurch gekennzeichnet, dass die Metallstreifen des Paars in der weiteren Metallisierungsebene jeweils an einer dem jeweils anderen Metallstreifen des Paars zugewandten Kante eine Teilaussparung über dem aktiven Bereich aufweisen.

Die Teilaussparungen bewirken eine veränderte thermische Anbindung der weiteren Metallisierungsebene an den aktiven Bereich des Transistors. Typisch wird sich der Leistungstransistor in diesem Bereich stärker erwärmen, sodass im durch die Kanten der Aussparung bestimmten Übergangsbereich Temperaturgradienten auftreten, die größer sind als bei Leistungstransistoren ohne Aussparung.

Im Zusammenwirken mit einer Detektionsstruktur in der Metallisierungsebene ermöglicht dies bei unveränderter Funktionssicherheit der Endstufe eine verbesserte Auslegung der Endstufe, das heißt im Allgemeinen weniger Siliziumflächenverbrauch.

Der erfindungsgemäße Transistor benötigt nur eine Detektorstruktur, die lateral signifikant weniger als 10% der Fläche über dem aktiven Gebiet verbraucht. Dadurch wird die Kontaktfläche für die Drain-und Sourcegebiete (beziehungsweise Kollektor- und Emittergebiete) lediglich geringfügig verringert und der Leitungsquerschnitt der zugehörigen Metallstrukturen nicht wesentlich beeinträchtigt, sodass die elektrische Anbindung des Transistors kaum beeinflusst und der Durchgangswiderstand nur minimal verschlechtert wird.

In einer bevorzugten Ausführungsform ist die Aussparung als solche, oder abgesehen von mindestens einem in die Aussparung hineinragenden Steg, oval, kreisförmig, rechteckförmig, rautenförmig oder oktogonal.

Dies sind leicht herstellbare Aussparungsformen.

Die beiden Metallstreifen des Paars erstrecken sich parallel zueinander in eine Erstreckungsrichtung und die Metallisierungsebene umfasst sich senkrecht zur Erstreckungsrichtung erstreckende Leiterbahnen aus einem Nutzmetall zur Leistungsverteilung. Dabei ist zwischen je zwei Leiterbahnen ein Detektorleiterbahnpaar zur Detektion eines bevorstehenden, durch RPP-Stress bedingten Metallisierungsfehlers angeordnet. Zwischen den Leiterbahnen und den Detektorleiterbahnen kann ein Zwischenschichtdielektrikum angeordnet sein.

Dann kann nämlich das Detektorleiterbahnpaar unter dem Steg angeordnet sein, wodurch eine besonders gute Detektion des Metallisierungsfehlers bewirkt wird. Oder mindestens eine Detektorleiterbahn des Detektorleiterbahnpaars kann einen Vorsprung aufweisen, sodass ein Abstand des Detektorleiterbahnpaars zueinander lokal verringert ist, wodurch eine besonders gute Detektion des Metallisierungsfehlers bewirkt wird.

Eine Kante des Vorsprungs kann unter einer Kante der Aussparung angeordnet sein, wodurch sich die Detektion noch einmal verbessern lässt.

Das Zwischenschichtdielektrikum kann zwischen den Detektionsleiterbahnen schmaler als zwischen den Leiterbahnen ausgebildet sein, sodass durch wiederholte Leistungspulse bedingter Stress das Zwischenschichtdielektrikum eher zwischen den Detektionsleiterbahnen als zwischen den stromtragenden Leiterbahnen schädigt.

So ist beispielsweise bei Auftreten eines Risses im Zwischenschichtdielektrikum zwischen zwei Detektionsleiterbahnen ein erhöhter Leckstrom messbar und damit ein kritischer Lebensdauerzeitpunkt vor Schädigung der stromtragenden Metallisierungsstruktur feststellbar.

Die Metallstreifen können Kupfer umfassen. Die weitere Metallisierungsebene kann eine Aluminium-Kupfer-Verbindung umfassen. Dies sind geeignete Metalle für die Metallisierungsebenen.

Erfindungsgemäß werden weiterhin ein Treiber gemäß Anspruch 8 mit einem erfindungsgemäßen Leistungstransistor und eine Endstufe gemäß Anspruch 9 für eine Fahrzeugkomponente mit einem erfindungsgemäßen Treiber vorgestellt. Besonders bei Fahrzeugkomponenten ist es zur Erhöhung der Bauteilsicherheit vorteilhaft, durch Frühwarnstrukturen überraschende Ausfälle in ihrer Anzahl zu verringern oder vollständig zu vermeiden.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 das Funktionsprinzip eines Low-Side-Schalters nach Stand der Technik,
Figur 2 schematisch einen Verlauf von Drainspannung und Drainstrom an einem FE-Transistor zur geklammerten Schaltung einer induktiven Last nach Stand der Technik bei Verwendung als Low-Side-Schalter,
Figur 3 einen Schnitt durch einen FE-Leistungstransistor nach Stand der Technik mit aufgeschmolzenem Metallisierungssystem,
Figur 4 eine beispielhafte schematische Darstellung eines Metallisierungssystems nach Stand der Technik,
Figur 5 eine Aufsicht auf eine obere Metallisierungsebene eines FE-Leistungstransistors gemäß einer ersten beispielhaften Ausführungsform der Erfindung,
Figur 6 eine Aufsicht auf eine obere Metallisierungsebene eines FE-Leistungstransistors gemäß einer zweiten beispielhaften Ausführungsform der Erfindung,
Figur 7 eine Aufsicht auf eine obere Metallisierungsebene eines FE-Leistungstransistors gemäß einer dritten beispielhaften Ausführungsform der Erfindung,
Figur 8 eine Aufsicht auf eine obere Metallisierungsebene eines FE-Leistungstransistors gemäß einer vierten beispielhaften Ausführungsform der Erfindung,
Figur 9 eine elektrothermische Simulation eines thermischen Profils eines FE-Leistungstransistors in Aufsicht,
Figur 10 das thermische Profil in einer ersten Schnittebene,
Figur 11 das thermische Profil in einer zur ersten Schnittebene senkrechten zweiten Schnittebene,
Figur 12 eine Aufsicht auf eine weitere Metallisierungsebene eines FE-Leistungstransistors gemäß einer weiteren beispielhaften Ausführungsform der Erfindung,
Figur 13 eine Aufsicht auf eine obere Metallisierungsebene eines FE-Leistungstransistors gemäß einer weiteren beispielhaften Ausführungsform,
Figur 14 einen beispielhaften Steg, wie er in der Erfindung Verwendung finden kann, und
Figur 15 eine beispielhafte Kerbe im Zwischenschichtdielektrikum, wie sie in der Erfindung Verwendung finden kann.

### Ausführungsformen der Erfindung

Figur 1 zeigt das Funktionsprinzip eines Low-Side-Schalters 10 nach Stand der Technik. Ein FE-Transistor 300 steuert eine induktive Last 400 an. Eine Zenerdiodenkette 100 zwischen Drain 320 und Gate 310 des FE-Transistors 300 schützt dabei vor kritischen Induktionsspannungen.

Figur 2 zeigt schematisch einen Verlauf von Drainspannung 20 und Drainstrom 30 an einem FE-Transistor nach Stand der Technik während eines Ein- und Ausschaltvorgangs. Die gestrichelte Kurve beschreibt einen resultierenden Temperaturverlauf 40 innerhalb des Bauelementes.

Figur 3 zeigt einen Schnitt durch einen FE-Leistungstransistor 300 nach Stand der Technik mit aufgeschmolzenem Metallisierungssystem. Der Schnitt wurde mit einem fokussierten Ionenstrahl bewirkt. Die Figur zeigt vollständig intakte aktive Bereiche des Endstufen-Transistors, wohingegen das Metallisierungssystem durch das Auftreten eines Kurzschlusses durch TPMD aufgeschmolzen wurde. Dieser Fehlermechanismus ist unter diesen Anwendungsbedingungen demnach signifikant für die Lebensdauer des FE-Transistors verantwortlich.

Figur 4 zeigt rechts, schematisch und beispielhaft, eine Ausbildung einer unteren Metallisierungsebene 600 eines FE-Leistungstransistors nach Stand der Technik zur Leistungsverteilung als Finger aus einer Aluminium-Kupfer-Legierung. Dies ist ein Ausschnitt der links schematisch und beispielhaft gezeigten, weiteren, oberen Metallisierungsebene 500 eines FE-Leistungstransistors nach Stand der Technik mit Metallelementen 510, 520 zur Leistungsversorgung, die im sogenannten "plated"·Layout als galvanisch voneinander getrennte und voneinander konstant beabstandete, sich zueinander parallel erstreckende Platten beziehungsweise Streifen ausgebildet sind. Eine Platte 510 dient der Leistungsversorgung des Drains über einen Drain-Anschluss 530 und die andere Platte 520 der Leistungsversorgung der Source über einen Source-Anschluss 540. Weitere Platten können vorhanden sein.

Gegenüber dem Stand der Technik verbessert die Erfindung durch gezielte lokale Anpassung des Metallisierungssystems die laterale Temperatur- und damit Stressverteilung und bildet zusammen mit Detektionsleiterbahnen eine Frühwarnstruktur für Back End-Degradation unter RPP-Stress. Die Anpassung des Metallisierungssystems grenzt den möglichen Ausfallort durch TPMD lokal stark ein, sodass im Vergleich zu den leistungsverteilenden Leiterbahnen im Metallisierungssystem schmale Metallfinger als lokale Detektionsleiterbahnen ausreichend sind, um einen kritischen Fortschritt der Degradation des FE-Transistors zu detektieren. Der laterale Flächenbedarf der Detektionsleiterbahnen ist hierbei so gering, dass die elektrische Anbindung des Transistors kaum beeinträchtigt wird. Die damit verbundene erhöhte Beherrschbarkeit der unvermeidbaren RPP-Degradation kann im Weiteren dazu genutzt werden, um FE-Endstufen bei variierenden Spezifikationsanforderungen flächeneffizienter zu entwerfen. Mittels einer Ansteuerungslogik kann ein weit fortgeschrittener Degradationszustand des FE-Transistors detektiert und eine Abfangmaßnahme beziehungsweise Frühwarnroutine gestartet werden. Dieses schützt vor einem plötzlichen Ausfall.

Durch die gezielte Anpassung des Metallisierungslayouts des FE-Transistors wird eine räumliche Beeinflussung des Fehlermechanismus aufgrund der veränderten lokalen lateralen Temperatur- und damit einhergehende Stressverteilung realisiert. Dadurch wird ein Ort des maximalen Stresses eingegrenzt.

Eine mögliche Realisierungsvariante betrifft den Fall, bei dem die leistungstragende obere Metallisierungsschicht im "plated"-Layout, also als sich in eine Erstreckungsrichtung erstreckende Platten, ausgeführt ist, und die untere leistungsverteilende Metallisierungsebene im "finger"-Layout, also als sich zu den Platten senkrecht erstreckende schmale Finger, ausgeführt sind.

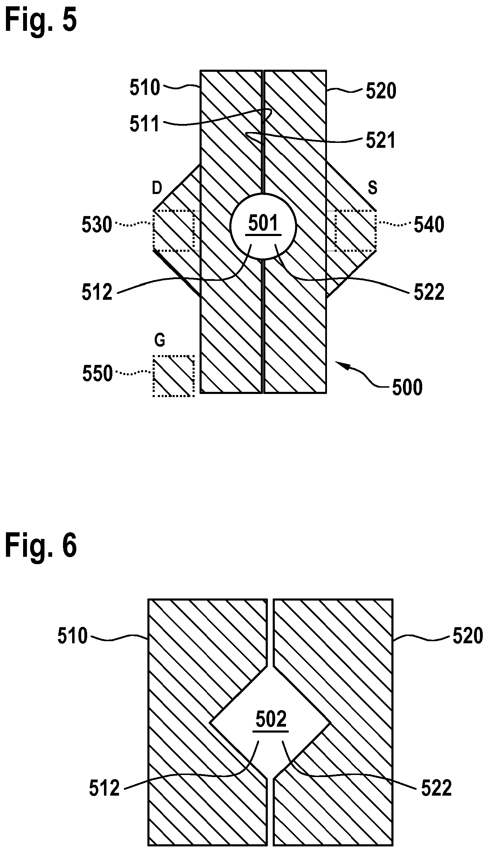

Figur 5, 6 und 7 zeigen Aufsichten auf einen FE-Leistungstransistor mit unterschiedlichen beispielhaften Ausführungsformen der Erfindung gemäß dieser Realisierungsvariante. In einer tiefer liegenden Metallisierungsebene erstrecken sich Detektionsleiterbahnen senkrecht zu einer Erstreckungsrichtung von Metallstreifen 510, 520 zur Leistungsversorgung von Source und Drain des FE-Leistungstransistors über einen Source-Anschluss 530 und einen Drain-Anschluss 540 in einer weiteren, oberen Metallisierungsebene 500.

In allen dargestellten beispielhaften Ausführungsformen dieser Realisierungsvariante weisen die Metallstreifen 510, 520 außerhalb eines zwischen Source-Anschluss 540 und einem Drain-Anschluss 530 angeordneten aktiven Bereichs des FE-Leistungstransistors konstanten Abstand zueinander auf. Weiterhin ist ein Gate-Anschluss 550 vorhanden.

In den Ausführungsbeispielen der Figuren 5 bis 9 weisen die Metallstreifen 510, 520 über dem aktiven Bereich jeweils an einer dem jeweils anderen Metallstreifen 510, 520 zugewandten Kante 511, 521 eine Teilaussparung 512, 522 auf. Die Teilaussparungen 512, 522 sind in allen dargestellten Ausführungsbeispielen dieser Realisierungsvariante spiegelsymmetrisch. In allen dargestellten Ausführungsbeispielen dieser Realisierungsvariante sind die Teilaussparungen 512, 522 so angeordnet, dass der durch die Teilaussparungen 512, 522 gebildete metallstreifenfreie Bereich 501, 502, 503, 504 der weiteren Metallisierungsebene mittig über dem aktiven Bereich angeordnet ist.

In der in Figur 5 gezeigten ersten beispielhaften Ausführungsform der Erfindung sind die Teilaussparungen 512, 522 jeweils halbkreisförmig und ergänzen sich zu einem Vollkreis 501.

In der in Figur 6 gezeigten zweiten beispielhaften Ausführungsform der Erfindung sind die Teilaussparungen 512, 522 jeweils dreieckig und ergänzen sich zu einer Raute 502.

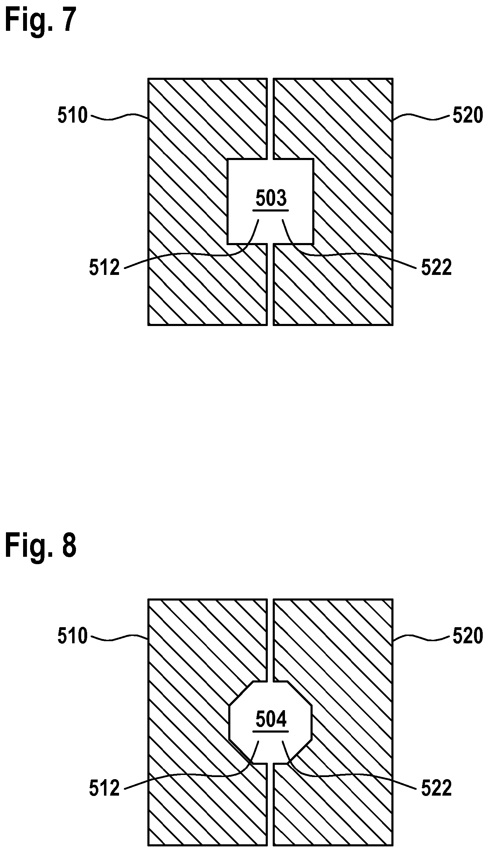

In der in Figur 7 gezeigten dritten beispielhaften Ausführungsform der Erfindung sind die Teilaussparungen 512, 522 jeweils rechteckig und ergänzen sich zu einem Quadrat 503.

In der in Figur 8 gezeigten vierten beispielhaften Ausführungsform der Erfindung ergänzen sich die Teilaussparungen 512, 522 zu einem Oktagon 504.

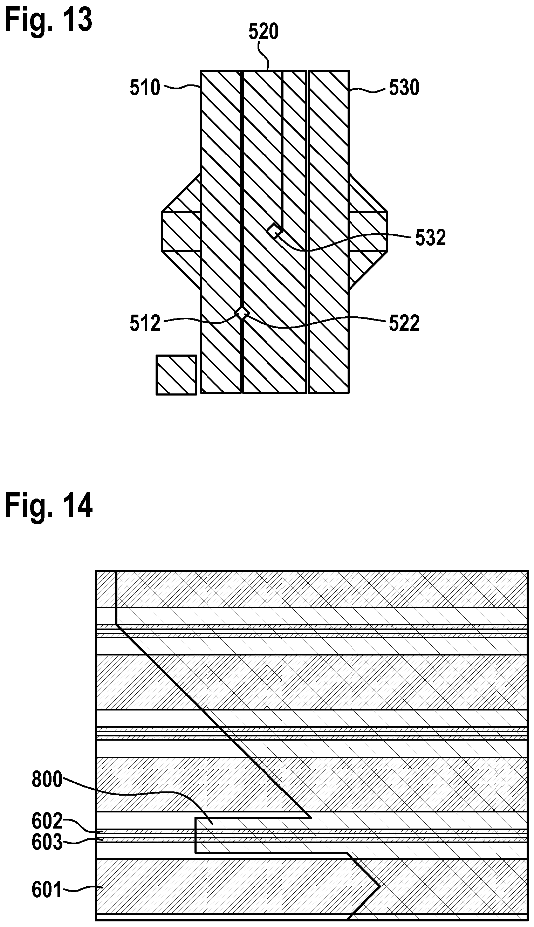

In der in Figur 13 gezeigten erfindungsgemäßen Ausführungsform sind die Teilaussparungen 512, 522 nicht mittig über dem aktiven Bereich angeordnet. Zusätzlich ist eine Aussparung 532 innerhalb derjenigen Platte 520 ausgebildet, die zur Leistungsversorgung der Source des Transistors dient. In einer beispielhaften, nicht erfindungsgemäßen Variante kann die Aussparung 532 auch die einzige Aussparung sein. Der in Figur 13 weiterhin gezeigte zusätzliche Metallstreifen 530 ist optional und dient zur Illustrierung, dass die Zahl der Metallstreifen über dem aktiven Bereich nicht auf zwei beschränkt ist.

Unabhängig von der prinzipiellen Grundform der jeweiligen Aussparung und ihrer Anordnung am Rand oder innerhalb einer Metallplatte können ein oder mehrere Stege senkrecht zur Erstreckungsrichtung der Platte in die Aussparung hineinragen, sodass die jeweilige Aussparung, abgesehen von dem Steg oder den Stegen, die jeweilige Grundform aufweist. Dies ist beispielhaft in Figur 14 gezeigt. Der Steg 800 ist an seiner Spitze über einen einzelnen Kontakt zur darunterliegenden Detektionsleiterbahn 602, 603 verbunden. Die so entstehende minimale Kontaktkette ermöglicht die Überwachung des Kontaktwiderstands und kann bei fortschreitendem thermomechanischen Stress ein Ablösen der oberen Metallisierungsebene vom Kontakt mithilfe einer Widerstandsmessung detektieren. Dies erhöht zusätzlich zur Detektion von Leckströmen, bedingt durch auftretende Risse im Zwischenmetalldielektrikum, die Detektionssicherheit der Alterung des Leistungstransistors.

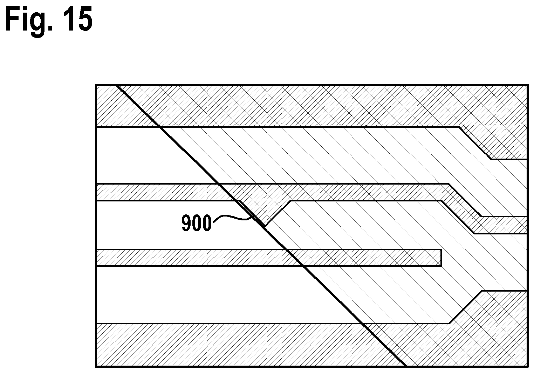

Figur 15 zeigt beispielhaft eine Weiterbildung, die mit allen vorangehenden Ausführungsbeispielen kombiniert werden kann. Mindestens eine der Detektorleiterbahnen 602, 603 weist in dieser Weiterbildung einen Vorsprung 900 auf, sodass ein Abstand des Detektorleiterbahnpaars 602, 603 zueinander lokal verringert ist. Der Vorsprung ist vorteilhafterweise im Bereich der Kante der Aussparung angeordnet. In Figur 15 ist der Vorsprung 900 so unter dem Metallelement mit der Aussparung angeordnet, dass eine Kante des Vorsprungs 900 mit einer Kante der Aussparung zusammenfällt. Dies ist jedoch nur eine Möglichkeit der Anordnung. In anderen Ausführungsbeispielen ist der Vorsprung ganz oder teilweise unter der Aussparung angeordnet. Beispielsweise kann der Vorsprung auch vollständig so unter der Aussparung angeordnet sein, dass eine Kante des Vorsprungs mit einer Kante der Aussparung zusammenfällt.

Die oberste leistungstragende Metallisierung ist also über dem aktiven Bereich so modifiziert, dass es zu einer lokalen Beeinflussung der Temperaturverteilung kommt. Die Aussparungen können beispielsweise hergestellt werden, indem auf einer entsprechenden Fläche Metall der Metallstreifen ausgespart wird.

Entscheidend für den erfinderischen Effekt ist eine lokale Vergrößerung des Abstands der Metallstreifen über einem begrenzten Bereich des aktiven Bereichs.

Dadurch kommt es zu einem lokal erhöhten Anteil an thermisch schlecht leitendem Zwischenschichtdielektrikum und damit zu einer Ausbildung einer thermischen Blase.

Die Fläche ist dabei in Abhängigkeit der Größe der Endstufe und ihrer gesamten lateralen Temperaturverteilung sinnvoll zu wählen, wohingegen die Form flexibel optimiert werden kann. Neben Raute, Quadrat, Kreis oder Oktagon sind auch andere Aussparungsformen umsetzbar. In einigen beispielhaften Ausführungsformen sind die Aussparungen nicht spiegelsymmetrisch. In einer nicht erfindungsgemäßen Variante weist zusätzlich oder alternativ zur nicht vorhandenen Spiegelsymmetrie nur eine der Platten eine Aussparung auf.

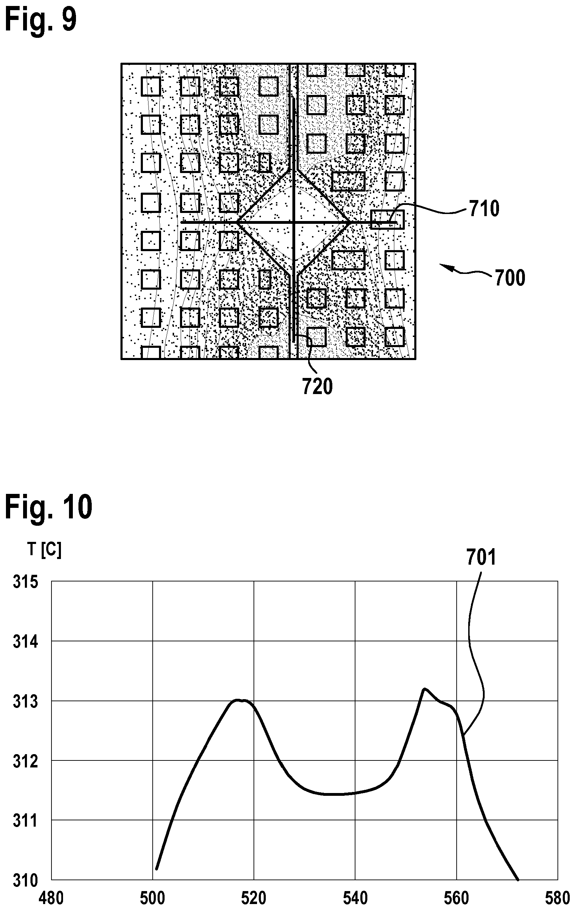

Der Einfluss dieser Modifikation auf die Temperaturverteilung innerhalb des Metallisierungssystems der Endstufe lässt sich mithilfe eines elektro-thermischen Simulators nachvollziehen. Für die Modifikation der leistungstragenden Metallisierung durch Ausschneiden einer Raute ist das simulierte thermische Profil 700 eines FE-Transistors in Figur 9 nach einem typischen Leistungspuls unter beschleunigten Randbedingungen in Aufsicht dargestellt.

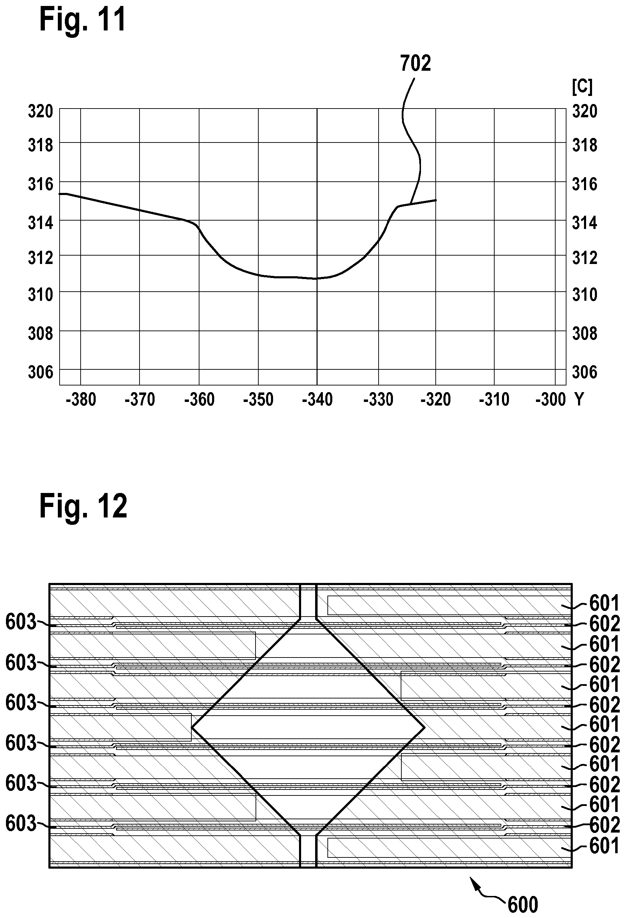

Figur 10 zeigt das thermische Teilprofil 701 des thermischen Profils aus Figur 9 in einer ersten Schnittebene 710 und Figur 11 zeigt das thermische Teilprofil 702 aus einer zur ersten Schnittebene 710 senkrechten zweiten Schnittebene 720.

Die Simulation zeigt, dass sich durch den lokal über dem aktiven Bereich vergrößerten Abstand einerseits eine geänderte Temperaturverteilung mit moderat geringeren Maximaltemperaturen im Vergleich zu einem nicht vergrößerten Abstand einstellt. Darüber hinaus wird jedoch ein hoher lokaler Temperaturgradient erzeugt, der maßgeblich für TPMD Effekte in den darunterliegenden leistungsverteilenden Metallisierungsschichten ist. Um diesen lokal erhöhten RPP-Stress zur Detektion der Degradation des FE-Transistors optimal nutzen zu können, kommen in der weiteren Metallisierungsebene 600 ein oder mehrere, im Vergleich zu den Leiterbahnen 601 schmalere, Detektionsleiterbahnen 602, 603 zum Einsatz, welche sich unterhalb der modifizierten Metallisierungsstruktur in den stromverteilenden Metalllagen befinden, wie beispielhaft in Figur 12 dargestellt ist. Diese können technologiespezifisch mit minimalem Abstand zueinander gezeichnet werden, um als Sollbruchstelle zu wirken, sodass der RPP-Stress bei den Detektionsleiterbahnen eher zu einem messbaren Effekt führt als im Fall der restlichen Nutzmetallisierung der Endstufe. So ist bei Auftreten eines Risses zwischen zwei Detektionsleiterbahnen ein erhöhter Leckstrom messbar und damit ein kritischer Lebensdauerzeitpunkt feststellbar. Zusätzlich ist es möglich gezielt eine Kerbe in das Zwischenmetalldielektrikum einzubringen, um die Entstehung eines Risses lokal zu beschleunigen (siehe Abbildungen A1 und A2). Mithilfe dieser überkritischen Struktur kann die Detektorstruktur weiter verkleinert werden. Die Detektionsleiterbahnen können dabei vorteilhafterweise so ausgelegt sein, dass der Alterungseffekt durch TPMD bei den Detektionsleiterbahnen sicher vor Erreichen der kritischen Alterungsgrenze der Endstufe aber nicht überkritisch früh auftritt, also beispielsweise nach etwa 80 % bis 90 % der Nutzlebensdauer der Endstufe. Dies ist beispielsweise durch geeignete Wahl von Länge, Breite, Abstand der Detektionsleiterbahnen zueinander und/oder die Spezifikation des typischerweise geschalteten Leistungspulses erreichbar. Eine beispielhafte Ausführungsform der vorliegenden Erfindung betrifft einen ASIC, der qualifiziert auf das TPMD-Fehlerereignis der Detektionsleiterbahnen reagieren kann, da er einen Ansteuerungsschaltkreis umfasst.

## Patentansprüche

1. Leistungstransistor (300) mit einem aktiven Bereich, einer über dem aktiven Bereich angeordneten Metallisierungsebene (600) zur Leistungsverteilung und zur Detektion eines bevorstehenden, durch wiederholtes Leistungspulsen verursachten Stress-, RPP-Stress-, bedingten Metallisierungsfehlers und einer über der Metallisierungsebene (600) angeordneten, weiteren Metallisierungsebene (500), in der sich galvanisch getrennte Metallstreifen (510, 520) in eine Erstreckungsrichtung parallel zueinander erstrecken, von denen ein Paar zur Leistungsversorgung des Leistungstransistors (300) dient, wobei sich die beiden Metallstreifen (510, 520) des Paars parallel zueinander in eine Erstreckungsrichtung erstrecken und die Metallisierungsebene (600) sich senkrecht zur Erstreckungsrichtung erstreckende Leiterbahnen (601) aus einem Nutzmetall zur Leistungsverteilung umfasst, wobei zwischen je zwei Leiterbahnen (601) ein Detektorleiterbahnpaar (602, 603) zur Detektion eines bevorstehenden, durch wiederholtes Leistungspulsen verursachten Stress-, RPP-Stress-, bedingten Metallisierungsfehlers angeordnet ist, **dadurch gekennzeichnet, dass** die Metallstreifen (510, 520) des Paars in der weiteren Metallisierungsebene (500) jeweils an einer dem jeweils anderen Metallstreifen (510, 520) des Paars zugewandten Kante eine Teilaussparung (512, 522) über dem aktiven Bereich aufweisen, wobei sich die Teilaussparungen (512, 522) zu einer Aussparung (501, 502, 503, 504) ergänzen.

2. Leistungstransistor (300) nach Anspruch 1, wobei die Aussparung (501, 502, 503, 504) oval, kreisförmig, rechteckförmig, rautenförmig oder oktogonal ist.

3. Leistungstransistor (300) nach Anspruch 1, wobei die Aussparung (501, 502, 503, 504) abgesehen von mindestens einem in die Aussparung (501, 502, 503, 504) hineinragenden Steg (800) oval, kreisförmig, rechteckförmig, rautenförmig oder oktogonal ist.

4. Leistungstransistor (300) nach Anspruch 3, wobei das Detektorleiterbahnpaar (602, 603) unter dem Steg (800) angeordnet ist.

5. Leistungstransistor (300) nach einem der vorangehenden Ansprüche, wobei mindestens eine Detektorleiterbahn (602, 603) des Detektorleiterbahnpaars (602, 603) einen Vorsprung (900) aufweist, sodass ein Abstand des Detektorleiterbahnpaars (602, 603) zueinander lokal verringert ist.

6. Leistungstransistor (300) nach Anspruch 5, wobei eine Kante des Vorsprungs (900) unter einer Kante der Aussparung (501, 502, 503, 504) angeordnet ist.

7. Leistungstransistor (300) nach einem der vorangehenden Ansprüche, wobei die Leiterbahnen (601) im Verhältnis zu den Detektionsleiterbahnen (602, 603) so breit ausgebildet sind, dass durch wiederholte Leistungspulse bedingter Stress die Detektionsleiterbahnen (602, 603) eher schädigt als die Leiterbahnen (601).

8. Treiber mit einem Leistungstransistor (300) nach einem der vorangehenden Ansprüche.

9. Endstufe für eine Fahrzeugkomponente mit einem Treiber nach Anspruch 8, wobei der Leistungstransistor (300) gemäß nach einem der vorangehenden Ansprüche ausgebildet ist und die Aussparung (501, 502, 503, 504) in ihrer Fläche in Abhängigkeit der Größe der Endstufe gewählt ist.

## Claims

1. Power transistor (300) having an active region, a metallization plane (600) arranged above the active region and serving for power distribution and for detection of an imminent metallization fault brought about by stress caused by repetitive power pulsing, RPP stress, and a further metallization plane (500), which is arranged above the metallization plane (600) and in which galvanically isolated metal strips (510, 520) extend parallel to one another in an extension direction, a pair of which metal strips serves for power supply of the power transistor (300), wherein the two metal strips (510, 520) of the pair extend parallel to one another in an extension direction and the metallization plane (600) comprises conductor tracks (601) composed of a useful metal for power distribution, said conductor tracks extending perpendicularly to the extension direction, wherein a detector conductor track pair (602, 603) for detecting an imminent metallization fault brought about by stress caused by repetitive power pulsing, RPP stress, is arranged between two respective conductor tracks (601),
**characterized in that** the metal strips (510, 520) of the pair in the further metallization plane (500) each have a partial cutout (512, 522) above the active region at an edge facing the respective other metal strip (510, 520) of the pair, wherein the partial cutouts (512, 522) complement one another to form a cutout (501, 502, 503, 504).

2. Power transistor (300) according to Claim 1, wherein the cutout (501, 502, 503, 504) is oval, circular, rectangular, rhombic or octagonal.

3. Power transistor (300) according to Claim 1, wherein the cutout (501, 502, 503, 504) is oval, circular, rectangular, rhombic or octagonal apart from at least one web (800) projecting into the cutout (501, 502, 503, 504).

4. Power transistor (300) according to Claim 3, wherein the detector conductor track pair (602, 603) is arranged below the web (800).

5. Power transistor (300) according to any of the preceding claims, wherein at least one detector conductor track (602, 603) of the detector conductor track pair (602, 603) has a projection (900), such that a distance of the detector conductor track pair (602, 603) with respect to one another is locally reduced.

6. Power transistor (300) according to Claim 5, wherein an edge of the projection (900) is arranged below an edge of the cutout (501, 502, 503, 504).

7. Power transistor (300) according to any of the preceding claims, wherein the conductor tracks (601) are formed in relation to the detection conductor tracks (602, 603) with a width such that stress brought about by repetitive power pulses is more likely to damage the detection conductor tracks (602, 603) than the conductor tracks (601).

8. Driver comprising a power transistor (300) according to any of the preceding claims.

9. Output stage for a vehicle component comprising a driver according to Claim 8, wherein the power transistor (300) is formed according to any of the preceding claims and the cutout (501, 502, 503, 504), in terms of its area, is chosen depending on the size of the output stage.

## Revendications

1. Transistor de puissance (300) comportant une région active, un niveau de métallisation (600) disposé au-dessus de la région active pour la distribution de puissance et pour la détection d'un défaut de métallisation imminent induit par une contrainte provoquée par des impulsions de puissance répétées, ou contrainte RPP, et un autre niveau de métallisation (500) disposé au-dessus du niveau de métallisation (600), dans lequel des bandes métalliques galvaniquement séparées (510, 520) s'étendent parallèlement les unes aux autres dans une direction d'extension, dont une paire sert à l'alimentation en énergie du transistor de puissance (300), les deux bandes métalliques (510, 520) de la paire s'étendant parallèlement l'une à l'autre dans une direction d'extension et le niveau de métallisation (600) comprenant des pistes conductrices (601) constituées d'un métal utile pour la distribution de puissance et s'étendant perpendiculairement à la direction d'extension, une paire de pistes conductrices de détection (602, 603) pour la détection d'un défaut de métallisation imminent induit par une contrainte provoquée par des impulsions de puissance répétées, ou contrainte RPP, étant disposée entre chaque fois deux pistes conductrices (601),
**caractérisé en ce que** les bandes métalliques (510, 520) de la paire située dans l'autre niveau de métallisation (500) comportent respectivement, au-dessus de la région active, un évidement partiel (512, 522) sur un bord tourné vers l'autre bande métallique (510, 520) respective de la paire, les évidements partiels (512, 522) se complétant pour former un évidement (501, 502, 503, 504).

2. Transistor de puissance (300) selon la revendication 1, dans lequel l'évidement (501, 502, 503, 504) est ovale, circulaire, rectangulaire, en losange ou octogonal.

3. Transistor de puissance (300) selon la revendication 1, dans lequel l'évidement (501, 502, 503, 504) est, à l'exception d'au moins une nervure (800) faisant saillie dans l'évidement (501, 502, 503, 504), ovale, circulaire, rectangulaire, en losange ou octogonal.

4. Transistor de puissance (300) selon la revendication 3, dans lequel la paire de pistes conductrices de détection (602, 603) est disposée au-dessous de la nervure (800).

5. Transistor de puissance (300) selon l'une des revendications précédentes, dans lequel au moins une piste conductrice de détection (602, 603) de la paire de pistes conductrices de détection (602, 603) présente une saillie (900), de sorte qu'une distance de la paire de pistes conductrices de détection (602, 603) l'une par rapport à l'autre est localement réduite.

6. Transistor de puissance (300) selon la revendication 5, dans lequel un bord de la saillie (900) est disposé au-dessous d'un bord de l'évidement (501, 502, 503, 504).

7. Transistor de puissance (300) selon l'une des revendications précédentes, dans lequel les pistes conductrices (601) sont configurées avec une largeur telle, par rapport aux pistes conductrices de détection (602, 603), qu'une contrainte induite par des impulsions de puissance répétées endommage les pistes conductrices de détection (602, 603) plus tôt que les pistes conductrices (601).

8. Circuit d'attaque comportant un transistor de puissance (300) selon l'une des revendications précédentes.

9. Étage de sortie pour un composant de véhicule comportant un circuit d'attaque selon la revendication 8, dans lequel le transistor de puissance (300) est configuré selon l'une des revendications précédentes et l'évidement (501, 502, 503, 504) est choisi, en ce qui concerne sa surface, en fonction de la taille de l'étage de sortie.
